# EUROPEAN PATENT SPECIFICATION

(11) **EP 2 937 402 B1**
(45) Date of publication and mention of the grant of the patent: **18.11.2020**
(21) Application number: 14814288.8
(22) Date of filing: 17.06.2014
(51) Int. Cl.: C09K 19/38, C09D 11/10, G03F 7/027, G03F 7/004, C09D 11/101, C09K 19/06, C09K 19/32, C09K 19/36, C09K 19/58, C09K 19/04, C09K 19/12, C09K 19/30, C09K 19/34, G03F 7/029, G03F 7/031, G03F 7/038, C09K 19/20, C09K 19/52

(54) **USE OF A LIQUID CRYSTAL COMPOSITION AS AN INK OR AS A COLORANT**
VERWENDUNG EINER FLÜSSIGKRISTALLZUSAMMENSETZUNG ALS TINTE ODER FARBMITTEL
UTILISATION D'UNE COMPOSITION DE CRISTAUX LIQUIDES COMME ENCRE OU COLORANT

(30) Priority: 21.06.2013 CN 201310251650
(43) Date of publication of application: 28.10.2015
(73) Proprietor: Huizhou Foryou Optical Technology Co. Ltd., Huizhou, Guangdong 516005 (CN)
(72) Inventor: CHEN, Zhangrong, Huizhou Guangdong 516005 (CN); SONG, Desheng, Huizhou Guangdong 516005 (CN); LIU, Wendi, Huizhou Guangdong 516005 (CN)
(74) Representative: de Arpe Fernandez, Manuel
(86) International application number: PCT/CN2014/080100
(87) International publication number: WO 2014/201997

(56) References cited:
- WO-A1-2004/021531
- WO-A1-2008/012292
- WO-A1-2011/120620
- WO-A1-2012/076534
- WO-A2-2009/121605
- CN-A- 1 141 645
- CN-A- 1 223 657
- GB-A- 2 315 072
- GB-A- 2 315 760
- JP-A- 2004 099 861
- US-A1- 2011 255 073
- US-A1- 2011 255 073

## Description

### FIELD OF THE INVENTION

The present disclosure relates to the technical field of the use of liquid crystal materials, and more particularly, to the use of a liquid crystal composition as an ink or as a colorant.

### BACKGROUND OF THE INVENTION

Liquid crystal is physically anisotropic. It is a transitional intermediate phase material having part of properties of both the crystal and the liquid, and plays an important role in many fields including biomedicine, electro-communication, aviation and navigation. In such macromolecules, a cholesteric phase liquid crystal monomer with a spiral structure is especially striking because it has excellent optical properties and can be used in novel optical materials, electronic and absorbing materials, so it has a promising application prospect.

The Japanese patent application JP2004099861A relates to a coating composition for forming a liquid crystal layer capable of forming a liquid crystal film without dissolving an oriented film or a stretched film on a base when a liquid crystal material-containing coating liquid used for forming a liquid crystal layer is applied on the base, and obtaining a smooth liquid crystal film without generating uneven coating film on application, and to provide an optical element using the composition. The coating composition for forming the liquid crystal layer comprises a liquid crystal material and a solvent as principal components, where the solvent comprises components which do not dissolve the base on which the composition for forming the liquid crystal layer is applied or an oriented layer provided on the base, and the content of the solvent in the composition is 60 to 90wt.%.

The US patent application US20110255073A1 relates to a process for producing polymerized films with line texture or fingerprint texture or for producing substrates coated with polymerized films with line texture or fingerprint texture, to polymerized films, obtainable by this process, with line texture or fingerprint texture or substrates coated with polymerized films with line texture or fingerprint texture, to pigments obtainable by comminuting such films, to the use of such films, substrates or pigments as or in optical filter(s), polarizers, decorative media, forgeryproof markers, reflective media or for focusing light (in solar cells), to the use of such films as an antibacterial coating, to a forgeryproof marker which comprises such a film, and to a process for detecting forgeryproof markings.

The international application WO2009121605A2 relates to a marking of polymeric liquid crystal material having determined optical characteristics allowing its authentication and reading by a machine and its authentication by the human eye. The marking is applied onto an item, good or article by a variable information printing process. The marking is in the form of indicia representing a unique code which allows for an easy authentication by the human eye and a secure tracking and tracing of the marked item, good or article throughout is life cycle.

The international application WO2011120620A1 relates to a method for producing multicoloured coatings on substrates, whereby a first and a second coating composition are subsequently coated onto a substrate by partially overlapping each other in a wet-on-wet state, the first and the second coating containing a polymerisable nematic liquid crystal material, followed by polymerisation of the resulting coating, to a multicoloured coating produced by said method as well as to products comprising said multicoloured coating.

The international application WO2012076534A1 relates to a substrate having thereon a marking or layer comprising a cured chiral liquid crystal precursor composition, wherein the chiral liquid crystal precursor composition comprises at least one salt that changes the position of a selective reflection band exhibited by the cured composition compared to a position of a selective reflection band exhibited by a cured composition that does not contain the at least one salt, and wherein a modifying resin made from one or more polymerizable monomers is disposed between the substrate and the marking or layer and in contact with the marking or layer in one or more areas thereof, the modifying resin changing a position of the selective reflection band exhibited by the cured chiral liquid crystal precursor composition comprising the at least one salt, on the substrate in the one or more areas.

The Great Britain patent application GB2315760A discloses a thermochromic polymerizable mesogenic composition essentially consisting of a) a component MA comprising at least one achiral polymerizable mesogenic compound comprising at least one polymerizable functional group, b) a component MB comprising at least one chiral polymerizable mesogenic compound comprising at least one polymerizable functional group, c) a photoinitiator, and d) optionally a dye component, (2) anisotropic polymers and polymer films with a chiral mesophase obtainable from said thermochromic polymerizable mesogenic composition and (3) the use of said thermochromic polymerizable mesogenic composition, anisotropic polymers and polymer films for optical information storage, photomasks, decorative pigments, cosmetics, security applications, active and passive optical elements such as polarizers or optical retarders, colour filters, scattering displays, adhesives or synthetic resins with anisotropic mechanical properties. The polymerizable composition is thermochromic, ie shows a change of colour upon temperature variation. By polymerizing at a particular temperature, a selected reflected wavelength band can obtained and subsequently "fixed" in the material by polymerization.

The Great Britain patent application GB2315072A discloses a circular UV polariser based on a polymerised mesogen being obtainable by curing by actinic radiation or by heat of a polymerisable composition which comprises the following components: a) a liquid mesogenic component A composed of one or more achiral mesogenic compounds having at least one polymerisable end group optionally linked via a spacer group to the mesogenic core, b) a component B composed of one or more chiral compounds in such an amount that the maximum wavelength of reflection (* small Greek lambda *max) of the composition is between 320 and 440 nm, and c) a photoinitiator or thermal initiator component C.

The international patent application WO2004021531A1 discloses a laser gain medium comprising at least one active species adapted to be stimulated to emit laser light within a predetermined wavelength range and optical feedback means defining a resonator for said laser light. The feedback means comprise at least one substantially solid cholesteric layer having a substantially planar texture exhibiting selective reflection of light defined by a reflection band tuned to said predetermined wavelength range.

The international patent application WO2008012292A1 discloses a liquid crystalline blend including at least one hardenable component A that is reflective in the UV and/or visible wavelength range, which contains at least one achiral, nematic, polymerizable monomer in combination with at least one chiral polymerizable monomer; at least one cholesteric polymerizable monomer; at least one cholesteric crosslinkable monomer; and/or at least one cholesteric polymer in a polymerizable diluent, and as component B at least one conjugated polycyclic compound that absorbs radiation and is optionally fluorescent. The invention also relates to the use of such blends for coating and printing substrates, in printing ink, in electro-optical components and/or in the forgery-proof marking of objects. Polymers or polymerized films that can be made by polymerization of the blend according to the invention are also the subject matter of the invention, as well as their use as optical filters, polarizers, means of decorating, forgery-proof marking or reflecting agents in the visible wavelength region; a method for printing or coating substrates, and substrates that can be obtained by this method; pigments that the blend according to the invention contains in hardened form, and coating materials that contain the pigments according to the invention.

The Chinese patent application CN1223657A discloses a chiral dopant of the general formula (I): R 1-X 1-MG 1-G-MG 2-X 2-R 2. The invention further relates to a liquid crystal material comprising at least one chiral dopant of the formula (I) and optionally at least one polymerizable mesogenic compound. The invention further relates to such a liquid crystal material for preparing a polymer film having a chiral liquid crystal phase, active and passive optical elements or color filters, and liquid crystal displays such as STN, TN, AMD-TN, temperature compensator, guest type Or phase change displays, or applications that do not contain polymer or polymer stabilized cholesteric texture (PFCT, PSCT) displays. The present invention also relates to a cholesteric liquid crystal display comprising a liquid crystal material of the chiral dopant of the general formula (I), and to a polymer film having a chiral liquid crystal phase, the liquid crystal phase being comprised by at least one pass The liquid crystal material of the chiral dopant of the formula (I) and optionally at least one polymerizable compound is obtained by (co)polymerization.

The Chinese patent application CN1141645A discloses a polymerizable, chiral compound containing at least one divalent or polyvalent chiral group, at least one polymerizable group, at least one spacer group and at least one mesogenic group, and The use as a polymerizable, chiral dopant when preparing a cholesteric network. The novel compounds are suitable for use in electro-optic displays or as chiral dopants for nematic or cholesteric liquid crystals to produce a layer that reflects color.

However, from the point of view of the development of existing technologies, the cholesteric phase liquid crystal monomer is mainly applied to optical films and liquid crystal pigments. Thus, it is especially important to study and develop the application methods of such material so that they can have excellent properties and afford higher social and economic benefits.

### SUMMARY OF THE INVENTION

The main technical problem to be solved by the present disclosure is to provide the use of a liquid crystal composition as an ink and as a colorant. This composition comprises no pigment particles or liquid crystal microcapsules, can be UV cured into a film, and is applicable to being printed onto various substrates through gravure or flexo printing and could have excellent properties, so that it has a promising application prospect.

To solve the aforesaid technical problem, a technical solution adopted by the present disclosure is: to provide the use of a liquid crystal composition as an ink and as a colorant according to claim 1, the liquid crystal composition comprises the following components in their respective mass percentages: 8%-50% of a polymerizable liquid crystal monomer; 1%-30% of a chiral reagent; 0.1%-5% of a photoinitiator; and 30%-70% of an organic solvent, wherein after being cured, the liquid crystal composition exhibits visual angle dependent optical effect, the liquid crystal composition comprises no liquid crystal microcapsules.

Specifically, the chiral reagent is at least one of acrylates, methacrylates, epoxy reins, methyl epoxy resins and alkenes containing with chiral centers, cholesterol, menthol and isosorbitol chiral groups; and the photoinitiator is at least one of a free radical initiator and a cationic initiator.

Specifically, the polymerizable liquid crystal monomer comprises at least one of mono-functional liquid crystal monomers and bi-functional liquid crystal monomers; the structural formula of the mono-functional liquid crystal monomer is P-Sp-X-M-R, wherein P is arbitrarily selected from one of CH₂=CW-COO-, WCH=CH-O-, and 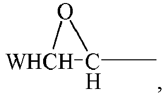 W is arbitrarily selected from one of H, -CH₃ and Cl, Sp is arbitrarily selected from one of spacer groups with a chain length of 3-30 carbon atoms, X is arbitrarily selected from one of -O-, -S-, -CO-, -COO-, -OCO-, -CO-NH-, -NH-CO-, -CH₂CH₂-, -OCH₂-, -CH₂O-, -SCH₂-, -CH₂S-, -CH=CH- and -CH=CH-COO-, M is a mesogenic group, and R is arbitrarily selected from H, CN, Cl, alkoxy, straight-chain alkanes, branched alkanes and cycloalkanes; wherein the structural formula of the mesogenic group M is -A¹-Z¹-(A²-Z²-)ₘ-A³-, Z¹ and Z² are each independently selected from one of -COO-, -OCO-, -CH₂CH₂-, -OCH₂-, -CH₂O-, -CH=CH-, -CH=CH-COO-, -OCO-CH=CH- and -C≡C-, m is 0, 1, or 2, A¹, A², and A³ are each independently selected from one of 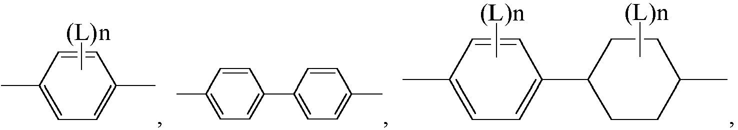 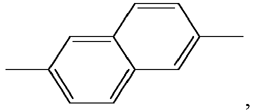 and 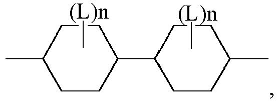 L is arbitrarily selected from one of H, F, Cl, CN, OH, NO₂, CH₃, C₂H₅, OCH₃, OC₂H₅, COCH₃, COOCH₃, COOC₂H₅, CF₃, OCF₂, and OC₂F₅, and n is 0, 1, or 2. Specifically, the structural formula of the bi-functional liquid crystal monomer is P¹-Sp¹-X¹-Y-X²-Sp²-P², wherein P¹ and P² are arbitrarily selected from one of CH₂=CW-COO-, WCH=CH-O-, and 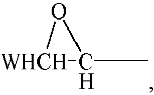 W is arbitrarily selected from one of H, -CH₃ and Cl, Sp¹ and Sp² are arbitrarily selected from one of spacer groups with a chain length of 3-30 carbon atoms, X¹ and X² are each arbitrarily selected from one of -O-, -S-, -CO-, -COO-, -OCO-, -CO-NH-, -NH-CO-, -CH₂CH₂-, -OCH₂-, -CH₂O-, -SCH₂-, -CH₂S-, -CH=CH- and -CH=CH-COO-, Y is a mesogenic group, the structural formula of the mesogenic group Y is -A⁴-Z³-(A⁵-Z⁴)ₘ-A⁶-, Z³ and Z⁴ are each independently selected from one of -COO-, -OCO-, -CH₂CH₂-, -OCH₂-, -CH₂O-, -CH=CH-, -CH=CH-COO-, -OCO-CH=CH- and -C≡C-, m is 0, 1, or 2, A⁴, A⁵, and A⁶ are each independently selected from one of 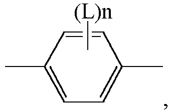 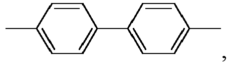 and 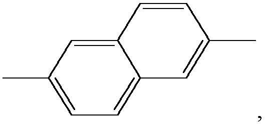 L is arbitrarily selected from one of H, F, Cl, CN, OH, NO₂, CH₃, C₂H₅, OCH₃, OC₂H₅, COCH₃, COOCH₃, COOC₂H₅, CF₃, OCF₂, and OC₂F₅, and n is 0, 1, or 2.

Specifically, the structure formula of the chiral reagent is P³-Sp³-X³-G-X⁴-Sp⁴-P⁴ or P⁵-Sp⁵-X⁵-F, wherein P³ and P⁴ are each independently selected from one of CH₂=CW-COO-, WCH=CH-O- and 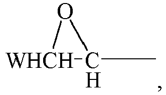 , W is arbitrarily selected from one of H, -CH₃ and Cl, Sp³ and Sp⁴ are each arbitrarily selected from one of spacer groups with a chain length of 3-30 carbon atoms, X³ and X⁴ are each independently selected from one of -O-, -S-, -CO-, -COO-, -OCO-, -CO-NH-, -NH-CO-, -CH₂CH₂-, -OCH₂-, -CH₂O-, -SCH₂-, -CH₂S-, -CH=CH-, and -CH=CH-COO-, G is arbitrarily selected from one of 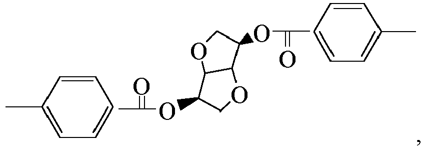 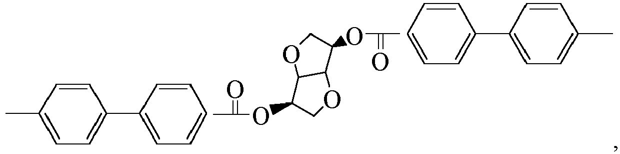 and 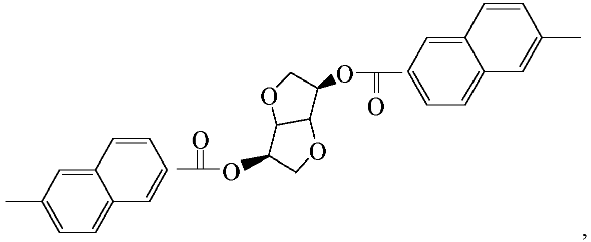 P⁵ is arbitrarily selected from one of CH₂=CW-COO-, WCH=CH-O- and 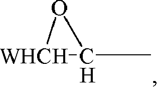 W is arbitrarily selected from one of H, -CH₃ and Cl, Sp⁵ is arbitrarily selected from one of spacer groups with a chain length of 3-30 carbon atoms, X⁵ is arbitrarily selected from one of -COO- and -CH=CH-COO-, and F is arbitrarily selected from one of 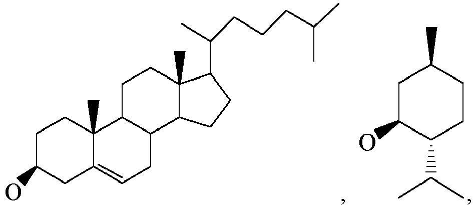 and

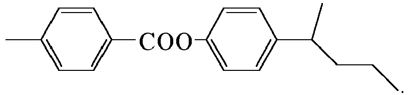

Specifically, the mono-functional liquid crystal monomer is at least one of 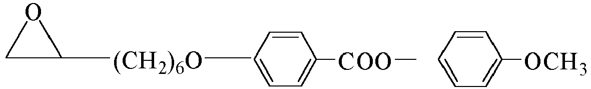 and

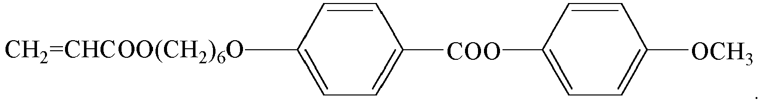

Specifically, the bi-functional liquid crystal monomer is at least one of 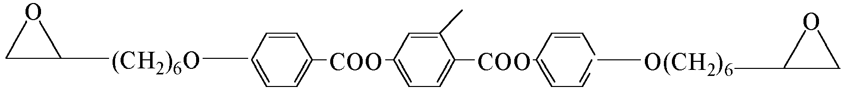 and

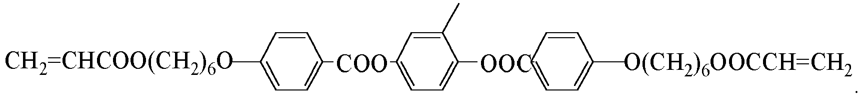

Specifically, the chiral reagent is at least one of 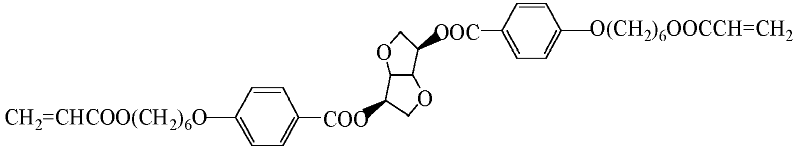 and

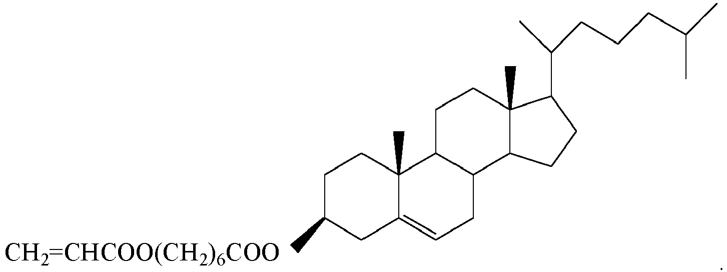

Specifically, the composition further comprises 0.1%-1% of an antioxidant and 0.01%-0.1% of an assistant, wherein the antioxidant is any one of hydroquinone, methoxyhydroquinone, benzoquinone, mono-tert-butylhydroquinone, pyrocatechol, p-tert-butylpyrocatechol, benzoquinone, 2,5-di-tert-butylhydroquinone, 2,5-dimethyl-p-benzoquinone, anthraquinone, and 2,6-di-tert-butyl-p-cresol; and the assistant is at least one of a fluorocarbon surfactant or an organosilicon surfactant.

Specifically, the composition further comprises 0.1%-1% of a tackifier which is at least one of the monomers, oligomers and prepolymers of acrylates, methacrylates, and epoxy acrylates having polymerizable groups.

Specifically, the photoinitiator is at least one of dimethoxybenzoin, 1-hydroxyketone, BDMB, phenyl bis(2,4,6-trimethylbenzoyl)-phosphine oxide, diazonium salt, diaryliodonium salt, triarylsulfonium salt, alkyl sulfonium salt, iron arene salt, sulfonyloxyketone, and triarylsiloxane.

Specifically, the organic solvent is at least one of toluene, xylene, ethylene glycol monomethylether, propylene glycol monomethyl ether, ethyl acetate, n-butyl acetate, n-propyl acetate, isobutyl acetate, amyl acetate, butanone, methyl isobutyl ketone, and isophorone.

The benefits of the present disclosure are as follows: as compared to the prior art, in the use of a liquid crystal composition according to the present disclosure, the liquid crystal composition comprises a polymerizable liquid crystal monomer, a chiral reagent, a photoinitiator and a solvent. The liquid crystal composition of the present disclosure contains no pigment particles or liquid crystal microcapsules, and after being cured exhibits visual angle dependent optical effect. Because the liquid crystal composition of the present disclosure contains no pigment particles, it is free of the phenomenon of coloring and poor discoloration effect as a result of arrangement of pigment pieces. Further, the composition contains no liquid crystal microcapsules, so after being UV cured into a film, it does not change as the external conditions (such as temperature, magnetic field and pressure) change. Thus, the liquid crystal composition of the present disclosure has excellent properties.

Additionally, the liquid crystal composition provided by the present disclosure can be used as an oil ink, a colorant or the like and can be printed onto various substrates such as glass, stainless steel, iron sheet, copper printing paper and plastics through gravure or flexo printing, so that it has a promising application prospect.

### DETAILED DESCRIPTION OF THE INVENTION

The present disclosure is to be further described in conjunction with specific embodiments, but the present disclosure is not limited to the illustrated specific embodiments.

The liquid crystal composition of the present disclosure comprises a polymerizable liquid crystal monomer, a chiral reagent, a photoinitiator and an organic solvent, wherien the mass percentages of the components are as follows: 8%-50% of the polymerizable liquid crystal monomer; 1%-30% of the chiral reagent; 0.1%-5% of the photoinitiator; and 30%-70% of the organic solvent, wherein the liquid crystal composition of the present disclosure after being cured exhibits visual angle dependent optical effect, the liquid crystal composition comprises no liquid crystal microcapsules.

Specifically, the polymerizable liquid crystal monomer may be at least one of mono-functional liquid crystal monomers and bi-functional liquid crystal monomers. Specifically, in the embodiments of the present disclosure, the structural formula of the mono-functional liquid crystal monomer is P-Sp-X-M-R, wherein P is arbitrarily selected from one of CH₂=CW-COO-, WCH=CH-O-, and 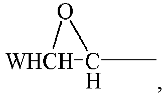 W is arbitrarily selected from one of H, -CH₃ and Cl, Sp is arbitrarily selected from one of spacer groups with a chain length of 3-30 carbon atoms, X is arbitrarily selected from one of -O-, -S-, -CO-, -COO-, -OCO-, -CO-NH-, -NH-CO-, -CH₂CH₂-, -OCH₂-, -CH₂O-, -SCH₂-, -CH₂S-, -CH=CH- and -CH=CH-COO-, M is a mesogenic group, and R is arbitrarily selected from H, CN, Cl, alkoxyl, straight-chain alkanes, branched alkanes and cycloalkanes; wherein the structural formula of the mesogenic group M is -A¹-Z¹-(A²-Z²-)ₘ-A³-, Z¹ and Z² are each independently selected from one of -COO-, -OCO-, -CH₂CH₂-, -OCH₂-, -CH₂O-, -CH=CH-, -CH=CH-COO-, -OCO-CH=CH- and -C≡C-, m is 0, 1, or 2, A¹, A², and A³ are each independently selected from one of 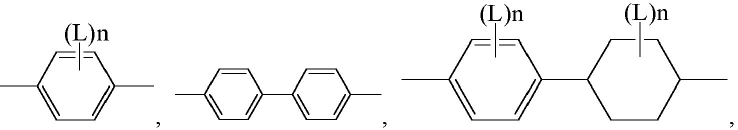 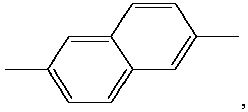 and 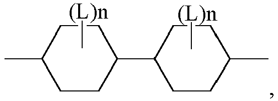 L is arbitrarily selected from one of H, F, Cl, CN, OH, NO₂, CH₃, C₂H₅, OCH₃, OC₂H₅, COCH₃, COOCH₃, COOC₂H₅, CF₃, OCF₂, and OC₂F₅, and n is 0, 1, or 2.

Specifically, the mono-functional liquid crystal monomer may be selected from at least one of 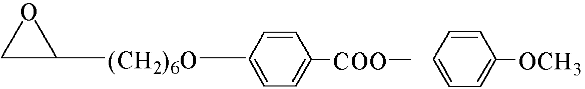 and

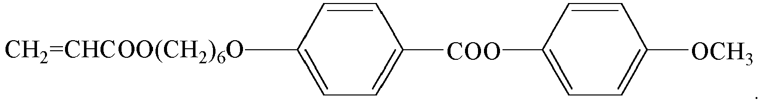

Specifically, in the embodiments of the present disclosure, the structural formula of the bi-functional liquid crystal monomer is: P¹-Sp¹-X¹-Y-X²-Sp²-P², wherein P¹ and P² are arbitrarily selected from one of CH₂-CW-COO-, WCH=CH-O-, and 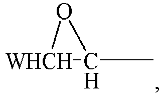 W is arbitrarily selected from one of H, -CH₃ and Cl, Sp¹ and Sp² are arbitrarily selected from one of spacer groups with a chain length of 3-30 carbon atoms, X¹ and X² are each arbitrarily selected from one of -O-, -S-, -CO-, -COO-, -OCO-, -CO-NH-, -NH-CO-, -CH₂CH₂-, -OCH₂-, -CH₂O-, -SCH₂-, -CH₂S-, -CH=CH- and -CH=CH-COO-, Y is a mesogenic group, the structural formula of the mesogenic group Y is -A⁴-Z³-(A⁵-Z⁴)ₘ-A⁶-, Z³ and Z⁴ are each independently selected from one of -COO-, -OCO-, -CH₂CH₂-, -OCH₂-, -CH₂O-, -CH=CH-, -CH=CH-COO-, -OCO-CH=CH- and -C≡C-, m is 0, 1, or 2, A⁴, A⁵, and A⁶ are each independently selected from one of 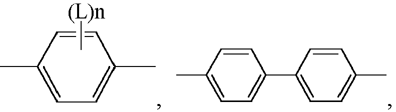 and 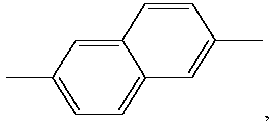 L is arbitrarily selected from one of H, F, Cl, CN, OH, NO₂, CH₃, C₂H₅, OCH₃, OC₂H₅, COCH₃, COOCH₃, COOC₂H₅, CF₃, OCF₂, and OC₂F₅, and n is 0, 1, or 2.

Specifically, the bi-functional liquid crystal monomer may be selected from at least one of 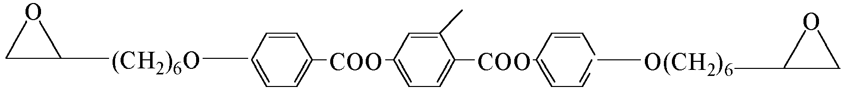 and

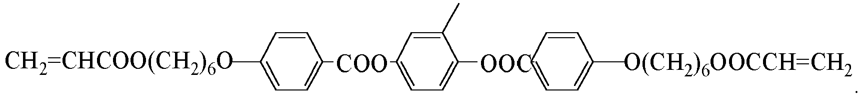

In the embodiments of the present disclosure, the chiral reagent may be polymerizable chiral reagents, for example at least one of acrylates, methacrylates, epoxy reins, methyl epoxy resins and alkenes containing cholesterol, menthol and isosorbitol chiral groups or chiral centers.

The structural formula of the chiral reagent is: P³-Sp³-X³-G-X⁴-Sp⁴-P⁴ or P⁵-Sp⁵-X⁵-F, wherein P³ and P⁴ are each independently selected from one of CH₂=CW-COO-, WCH=CH-O- and 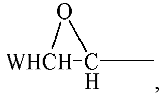 W is arbitrarily selected from one of H, -CH₃ and Cl, Sp³ and Sp⁴ are each arbitrarily selected from one of spacer groups with a chain length of 3-30 carbon atoms, X³ and X⁴ are each independently selected from one of -O-, -S-, -CO-, -COO-, -OCO-, -CO-NH-, -NH-CO-, -CH₂CH₂-, -OCH₂-, -CH₂O-, -SCH₂-, -CH₂S-, -CH=CH-, and -CH=CH-COO-, G is arbitrarily selected from one of 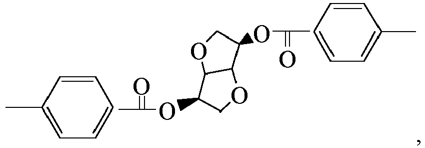 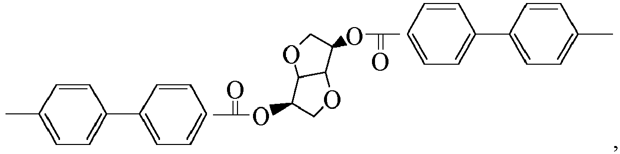 and 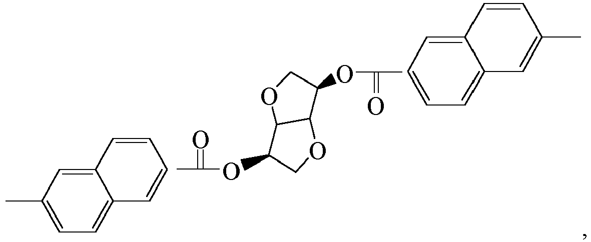 P⁵ is arbitrarily selected from one of CH₂=CW-COO-, WCH=CH-O- and 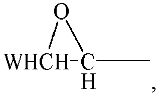 W is arbitrarily selected from one of H, -CH₃ and Cl, Sp⁵ is arbitrarily selected from one of spacer groups with a chain length of 3-30 carbon atoms, X⁵ is arbitrarily selected from one of -COO- and -CH=CH-COO-, and F is arbitrarily selected from one of 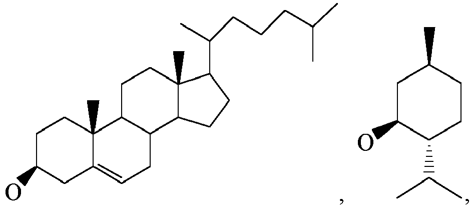 and

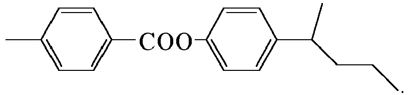

Specifically, the chiral reagent may be selected from at least one of 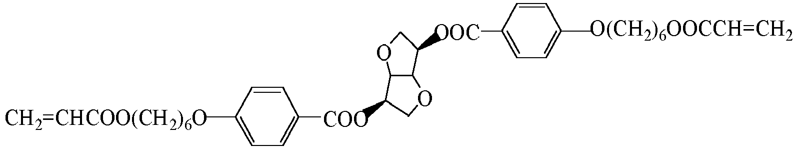 and

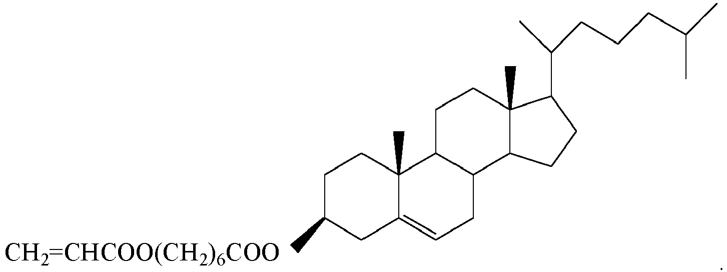

The photoinitiator may be at least one of a free radical initiator and a cationic initiators, for example, at least one of dimethoxybenzoin, 1-hydroxyketone, BDMB, phenyl bis(2,4,6-trimethylbenzoyl)-phosphine oxide, diazonium salt, diaryliodonium salt, triarylsulfonium salt, alkylsulfonium salt, iron arene salt, sulfonyloxyketone, and triarylsiloxane.

In the embodiments of the present disclosure, the organic solvent may be at least one of toluene, xylene, ethylene glycol monomethyl ether, propylene glycol monomethyl ether, ethyl acetate, n-butyl acetate, n-propyl acetate, iso-butyl acetate, amyl acetate, butanone, methyl isobutyl ketone, and isophorone.

In one embodiment of the liquid crystal composition of the present disclosure, the liquid crystal composition further comprises 0.1%-1% of an antioxidant and 0.01%-0.1% of an assistant.

Specifically, the antioxidant in the embodiments of the present disclosure may be selected from any one of hydroquinone, methoxyhydroquinone, p-benzoquinone, mono-tert-butylhydroquinone, pyrocatechol, p-tert-butylpyrocatechol, benzoquinone, 2,5-di-tert-butylhydroquinone, 2,5-dimethyl-p-benzoquinone, anthraquinone, and 2,6-di-tert-butyl-p-cresol.

The assistant may be selected from at least one of a fluorocarbon surfactant or an organosilicon surfactant.

Moreover, the liquid crystal composition of the present disclosure may further comprise 0. 1%-3% of a tackifier. Specifically, the material that may be used as the tackifier is at least one of the monomers, oligomers and prepolymers of acrylates, methacrylates, and epoxy acrylates having polymerizable groups.

It may be appreciated from the description of the aforesaid embodiments that, in the use of the liquid crystal composition as an ink or as a colorant according to the present disclosure, the liquid crystal composition comprises a liquid crystal monomer, a chiral reagent, a photoinitiator and a solvent. The liquid crystal composition contains no pigment particles or liquid crystal microcapsules, and after being cured exhibits visual angle dependent optical effect. Because the liquid crystal composition of the present disclosure contains no pigment particles, it is free of the phenomenon of coloring and poor discoloration effect as a result of arrangement of pigment pieces. Further, the composition contains no liquid crystal microcapsules, so after being UV cured into a film, it does not change as the external conditions (such as temperature, magnetic field and pressure) change. Thus, the liquid crystal composition of the present disclosure has excellent properties.

Additionally, the liquid crystal composition provided by the present disclosure can be used as an oil ink, a colorant or the like and can be printed onto various substrates such as glass, stainless steel, iron sheet, copper printing paper and plastics through gravure or flexo printing, so that it has a promising application prospect.

The liquid crystal composition of the present disclosure will be described through specific embodiments respectively hereinbelow. The components of the embodiments only give an example of one of the compositions, for example liquid crystal monomer, chiral reagent, photoinitiator, antioxidant, assistant and organic solvent. Other optional materials listed above are also applicable and will not be illustrated one by one in the present disclosure. For ease of description, the composition of the liquid crystal monomers in the following embodiments comprises compound 1 and compound 2, and the chiral reagent is represented by compound 3.

### Example 1

In this example, compound 1 is: 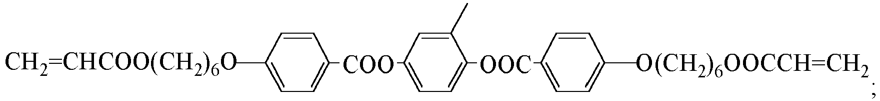 compound 2 is: 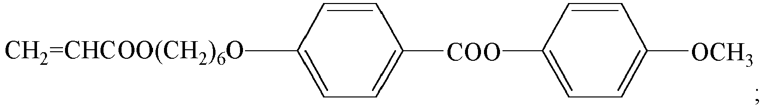 and compound 3 is

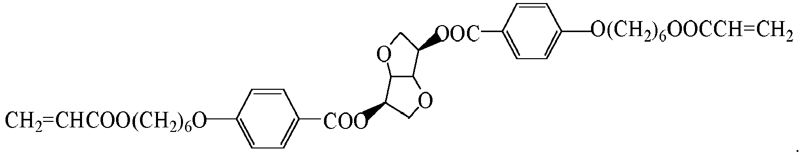

In this example, the photoinitiator adopts initiator 907 (Ciba), the antioxidant adopts antioxidant 703 (Nanjing YinQi Biology Engineering Co., Ltd.), the assistant adopts a fluorine-containing surfactant (Guangzhou Debang Chemical Co., Ltd.), and the organic reagent adopts butanone.

For the ratio between the components of this example, please refer to Table 1 below:

**Table 1: Mass Percentages of the Components of the Liquid Crystal Composition of Example 1**

| Component | Mass percentage |
|---|---|
| Compound 1 | 20.9% |
| Compound 2 | 10.46% |
| Compound 3 | 1.67% |
| Initiator 907(Ciba) | 0.67% |
| Antioxidant 703 (Nanjing YinQi Biology Engineering Co., Ltd.) | 0.17% |
| Fluorine-containing surfactant (Guangzhou Debang Chemical Co., Ltd.) | 0.03% |
| Butanone | 66.1% |

According to the aforesaid formula and amounts, compound 1, compound 2, compound 3 and butanone were placed into a stirrer where they were stirred at 50°C for half an hour first, and then the initiator 907, the antioxidant 703 and the fluorine-containing surfactant were added thereto. The mixture was further stirred for 10 min and filtered to obtain an optically variable liquid crystal composition. This liquid crystal composition could be used as an ink for ink-jet printing. This liquid crystal composition was cured into a film on substrates such as PET, glass, stainless steel, iron sheet, OPP, PE, and copper printing paper through a UV ink-jet printer, and the resulting film looks red when viewed from the front and green from the side.

### Example 2

In this example, compound 1 is: 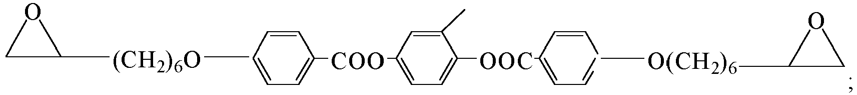 compound 2 is: 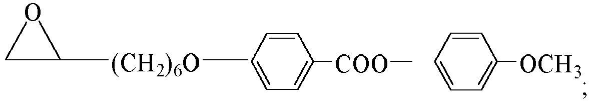 and compound 3 is

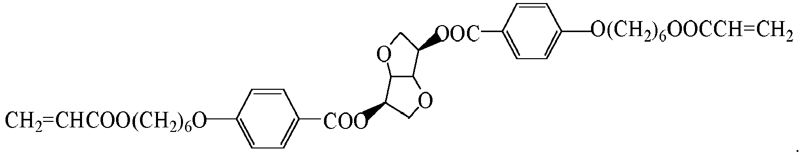

In this example, the photoinitiator adopts a cationic initiator ((phenylthio)phenyl-diphenyl sulfonium hexafluorophosphate, BASF), the antioxidant adopts antioxidant 703 (Nanjing YinQi Biology Engineering Co., Ltd.), the assistant adopts a fluorine-containing surfactant (Guangzhou Debang Chemical Co., Ltd.), and the organic reagent adopts butanone.

For the ratio between the components of this example, please refer to Table 2 below:

**Table 2: Mass Percentages of the Components of the Liquid Crystal Composition of Example 2**

| Component | Mass percentage |
|---|---|
| Compound 1 | 20.66% |
| Compound 2 | 10.33% |
| Compound 3 | 2.02% |
| Cationic initiator ((phenylthio)phenyl-diphenyl sulfonium hexafluorophosphate, BASF) | 0.82% |
| Antioxidant 703 (Nanjing YinQi Biology Engineering Co., Ltd.) | 0.12% |
| Fluorine-containing surfactant (Guangzhou Debang Chemical Co., Ltd.) | 0.05% |
| Butanone | 66.0% |

According to the aforesaid formula and amounts, compound 1, compound 2, compound 3 and butanone were placed into a stirrer where they were stirred at 50°C for half an hour first, and then initiator 907, antioxidant 703 and the fluorine-containing surfactant were added thereto. The mixture was further stirred for 10 min and filtered to obtain an optically variable liquid crystal composition. The liquid crystal composition prepared in this example could be used as an ink for ink-jet printing. This liquid crystal composition was cured into a film on substrates such as PET, glass, stainless steel, iron sheet, OPP, PE, and copper printing paper through a UV ink-jet printer, and the resulting film looks green when viewed from the front and blue from the side.

### Example 3

In this example, compound 1 is: 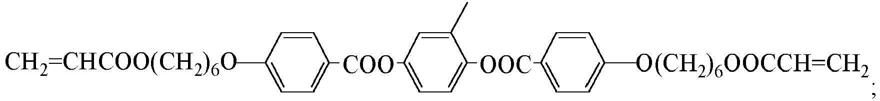 compound 2 is: 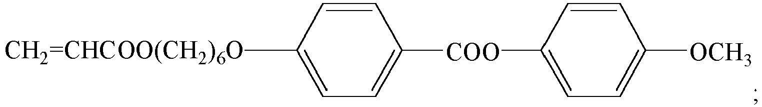 and compound 3 is

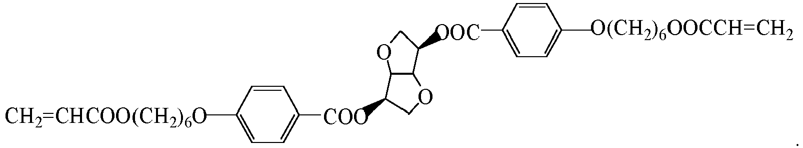

In this example, the photoinitiator adopts initiator 907 (Ciba), the antioxidant adopts antioxidant 703 (Nanjing YinQi Biology Engineering Co., Ltd.), the assistant adopts a fluorine-containing surfactant (Guangzhou Debang Chemical Co., Ltd.), and the organic reagent adopts butanone. The liquid crystal composition in this example further comprises a tackifier to increase the viscosity of the liquid crystal composition. The amount of the tackifier added could be controlled as required. In the embodiments of the present disclosure, the mass percentage of the tackifier in the composition is preferably 0.1%-1%, and further preferably 0.5%-1%, for example, 0.5%, 0.7%, 0.8% and 1%.

For the ratio between the components of this example, please refer to Table 3 below:

**Table 3: Mass Percentages of the Components of the Liquid Crystal Composition of Example 3**

| Component | Mass percentage |
|---|---|
| Compound 1 | 24% |
| Compound 2 | 12.53% |
| Compound 3 | 2% |
| Tackifier | 1% |
| Initiator 907(Ciba) | 0.8% |
| Antioxidant 703 (Nanjing YinQi Biology Engineering Co., Ltd.) | 0.2% |
| Fluorine-containing surfactant (Guangzhou Debang Chemical Co., Ltd.) | 0.07% |
| Butanone | 59.4% |

According to the aforesaid formula and amounts, compound 1, compound 2, compound 3, the tackifier and butanone were placed into a stirrer where they were stirred at 50°C for half an hour first, and then initiator 907, antioxidant 703 and the fluorine-containing surfactant were added thereto. The mixture was further stirred for 10 min, and filtered to obtain a liquid crystal composition. The liquid crystal composition in this example could be used as a liquid crystal ink. This liquid crystal composition was applicable to gravure and flexo printing and UV cured into a film on substrates such as PET, glass, stainless steel, iron sheet, OPP, PE, and copper printing paper, and the resulting film looks red when viewed from the front and green from the side.

### Example 4

In this example, compound 1 is: 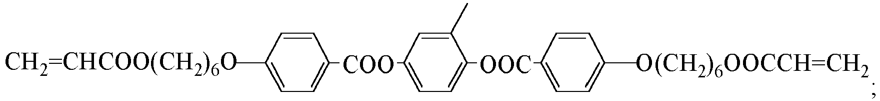 compound 2 is: 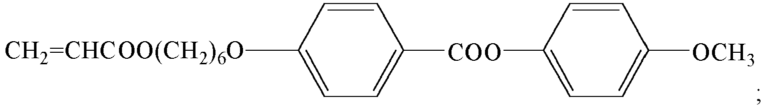 and compound 3 is

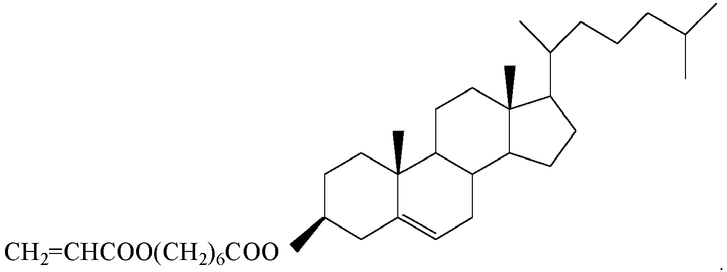

In this example, the photoinitiator adopts initiator 907 (Ciba), the antioxidant adopts antioxidant 703 (Nanjing YinQi Biology Engineering Co., Ltd.), the assistant adopts a fluorine-containing surfactant (Guangzhou Debang Chemical Co., Ltd.), and the organic reagent adopts butanone. The liquid crystal composition in this example further comprises a tackifier to increase the viscosity of the liquid crystal composition.

For the ratio between the components of this example, please refer to Table 4 below:

**Table 4: Mass Percentages of the Components of the Liquid Crystal Composition of Example 4**

| Component | Mass percentage |
|---|---|
| Compound 1 | 19.34% |
| Compound 2 | 11.9% |
| Compound 3 | 7.93% |
| Tackifier | 0.5% |
| Initiator 907(Ciba) | 0.16% |
| Antioxidant 703 (Nanjing YinQi Biology Engineering Co., Ltd.) | 0.63% |
| Fluorine-containing surfactant (Guangzhou Debang Chemical Co., Ltd.) | 0.04% |
| Butanone | 59.5% |

According to the aforesaid formula and amounts, compound 1, compound 2, compound 3, the tackifier and butanone were placed into a stirrer where they were stirred at 50°C for half an hour first, and then initiator 907, antioxidant 703 and the fluorine-containing surfactant were added thereto. The mixture was further stirred for 10 min, and filtered to obtain a liquid crystal composition. The liquid crystal composition prepared in this example could be used as a liquid crystal ink. This liquid crystal composition was applicable to gravure and flexo printing and UV cured into a film on substrates such as PET, glass, stainless steel, iron sheet, OPP, PE, and copper printing paper, and the resulting film looks orange red when viewed from the front and grass green from the side.

### Example 5

In this example, compound 1 is: 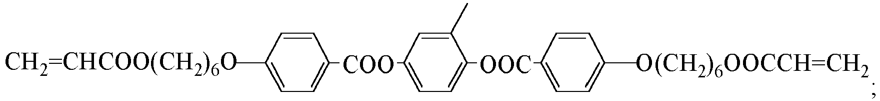 compound 2 is: 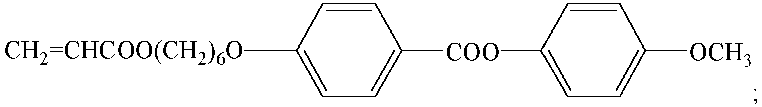 and compound 3 is

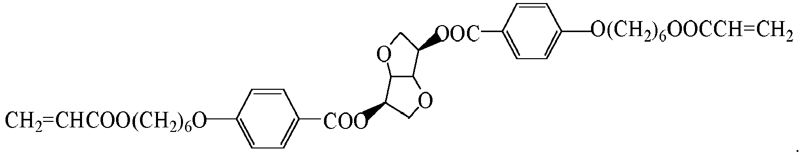

In this example, the photoinitiator adopts initiator 907 (Ciba), the antioxidant adopts antioxidant 703 (Nanjing YinQi Biology Engineering Co., Ltd.), the assistant adopts a fluorine-containing surfactant (Guangzhou Debang Chemical Co., Ltd.), and the organic reagent adopts butanone.

For the ratio between the components of this example, please refer to Table 5 below:

**Table 5: Mass Percentages of the Components of the Liquid Crystal Composition of Example 5**

| Component | Mass percentage |
|---|---|
| Compound 1 | 20.92% |
| Compound 2 | 10.46% |
| Compound 3 | 1.67% |
| Initiator 907(Ciba) | 0.67% |
| Antioxidant 703 (Nanjing YinQi Biology Engineering Co., Ltd.) | 0.16% |
| Fluorine-containing surfactant (Guangzhou Debang Chemical Co., Ltd.) | 0.02% |
| Butanone | 66.1% |

According to the aforesaid formula and amounts, compound 1, compound 2, compound 3 and butanone were placed into a stirrer where they were stirred at 50°C for half an hour first, and then initiator 907, antioxidant 703 and the fluorine-containing surfactant were added thereto. The mixture was further stirred for 10 min, and filtered to obtain a liquid crystal composition. The liquid crystal composition prepared in this example could be used as a liquid colorant. This liquid crystal composition was applicable to substrates such as PET, glass, stainless steel, iron sheet, OPP, PE, and copper printing paper. It was UV cured into a film which looks red when viewed from the front and green from the side.

### Example 6

In this example, compound 1 is: 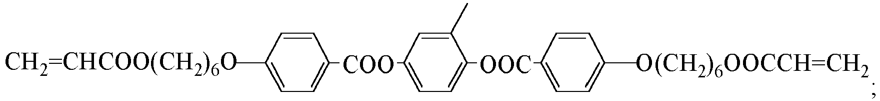 compound 2 is: 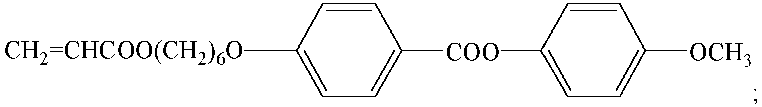 and compound 3 is

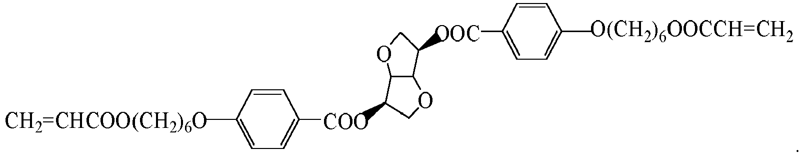

In this example, the photoinitiator adopts initiator 907 (Ciba), and the organic reagent adopts butanone.

For the ratio between the components of this example, please refer to Table 6 below:

**Table 6: Mass Percentages of the Components of the Liquid Crystal Composition of Example 6**

| Component | Mass percentage |
|---|---|
| Compound 1 | 26.3% |
| Compound 2 | 13.6% |
| Compound 3 | 2.11% |
| Initiator 907(Ciba) | 0.72% |
| Butanone | 68.3% |

According to the aforesaid formula and amounts, compound 1, compound 2, compound 3 and butanone were placed into a stirrer where they were stirred at 50°C for half an hour first, and then initiator 907was added thereto. The mixture was further stirred for 10 min, and filtered to obtain an optically variable liquid crystal composition. This liquid crystal composition could be used as an ink for ink-jet printing, a liquid crystal ink or a liquid colorant. This liquid crystal composition was cured into a film on substrates such as PET, glass, stainless steel, iron sheet, OPP, PE, and copper printing paper through a UV ink-jet printer. The resulting film looks red when viewed from the front and green from the side.

What described above are the specific embodiments of the present disclosure and the equivalent replacements of other equivalent substances are also covered within the scope of the present disclosure.

According to the description of the aforesaid embodiments, in the use of the liquid crystal composition as an ink or as a colorant provided by the present disclosure, the liquid crystal composition may comprise a polymerizable liquid crystal monomer, a chiral reagent, a photoinitiator and a solvent. This liquid crystal composition contains no pigment particles or liquid crystal microcapsules, and after being cured exhibits visual angle dependent optical effect. Because the liquid crystal composition of the present disclosure contains no pigment particles, it is free of the phenomenon of coloring and poor discoloration effect as a result of arrangement of pigment pieces. Further, the composition contains no liquid crystal microcapsules, so after being UV cured into a film, it does not change as the external conditions (such as temperature, magnetic field and pressure) change. Thus, the liquid crystal composition of the present disclosure has excellent properties.

Additionally, the liquid crystal composition provided by the present disclosure can be used as an oil ink, a colorant or the like and can be printed onto various substrates such as glass, stainless steel, iron sheet, copper printing paper and plastics through gravure or flexo printing, so that it has a promising application prospect.

What described above are only the embodiments of the present disclosure, but are not intended to limit the scope of the present disclosure.

## Claims

1. The use of a liquid crystal composition as an ink or as a colorant, said liquid crystal composition comprising the following components in their respective mass percentages:
8%-50% of a polymerizable liquid crystal monomer;
1%-30% of a chiral reagent;
0.1%-5% of a photoinitiator; and
30%-70% of an organic solvent,
wherein after being cured, the liquid crystal composition exhibits visual angle dependent optical effect;
it is **characterized in that** the liquid crystal composition comprises no liquid crystal microcapsules.

2. The use of the liquid crystal composition as an ink or as a colorant of claim 1, wherein,
the chiral reagent is at least one of acrylates, methacrylates, epoxy reins, methyl epoxy resins and alkenes containing cholesterol, menthol and isosorbitol chiral groups or chiral centers; and
the photoinitiator is at least one of a free radical initiator and a cationic initiator.

3. The use of the liquid crystal composition as an ink or as a colorant of claim 2,
wherein the polymerizable liquid crystal monomer comprises at least one of mono-functional liquid crystal monomers and bi-functional liquid crystal monomers; the structural formula of the mono-functional liquid crystal monomer is P-Sp-X-M-R, wherein P is arbitrarily selected from one of CH₂-CW-COO-, WCH=CH-O-, and 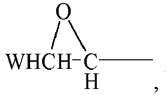 W is arbitrarily selected from one of H, -CH₃, and Cl, Sp is arbitrarily selected from one of spacer groups with a chain length of 3-30 carbon atoms, X is arbitrarily selected from one of -O-, -S-, -CO-, -COO-, -OCO-, -CO-NH-, -NH-CO-, -CH₂CH₂-, -OCH₂-, -CH₂O-, -SCH₂-, -CH₂S-, -CH=CH- and -CH=CH-COO-, M is a mesogenic group, and R is arbitrarily selected from H, CN, Cl, alkoxyl, straight-chain alkanes, branched alkanes and cycloalkanes;
wherein, the structural formula of the mesogenic group M is -A¹-Z¹-(A²-Z² -)ₘ-A³-, Z¹ and Z² are each independently selected from one of -COO-, -OCO-, -CH₂CH₂-, -OCH₂-, -CH₂O-, -CH=CH-, -CH=CH-COO-, -OCO-CH=CH- and -C≡C-, m is 0, 1, or 2, A¹, A², and A³ are each independently selected from one of 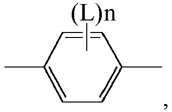 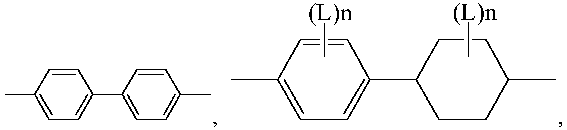 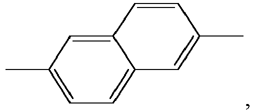 and 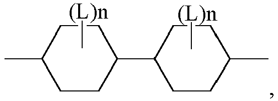 L is arbitrarily selected from one of H, F, Cl, CN, OH, NO₂, CH₃, C₂H₅, OCH₃, OC₂H₅, COCH₃, COOCH₃, COOC₂H₅, CF₃, OCF₂, and OC₂F₅, and n is 0, 1, or 2.

4. The use of the liquid crystal composition as an ink or as a colorant of claim 2, wherein the structural formula of the bi-functional liquid crystal monomer is P¹-Sp¹-X¹-Y-X²-Sp²-P², wherein P¹ and P² are arbitrarily selected from one of CH₂=CW-COO-, WCH=CH-O-, and 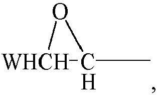 W is arbitrarily selected from one of H, -CH₃ and Cl, Sp¹ and Sp² are arbitrarily selected from one of spacer groups with a chain length of 3-30 carbon atoms, X¹ and X² are each arbitrarily selected from one of -O-, -S-, -CO-, -COO-, -OCO-, -CO-NH-, -NH-CO-, -CH₂CH₂-, -OCH₂-, -CH₂O-, -SCH₂-, -CH₂S-, -CH=CH- and -CH=CH-COO-, Y is a mesogenic group, the structural formula of the mesogenic group Y is -A⁴-Z³-(A⁵ -Z⁴)ₘ-A⁶-, Z³ and Z⁴ are each independently selected from one of -COO-, -OCO-, -CH₂CH₂-, -OCH₂-, -CH₂O-, -CH=CH-,-CH=CH-COO-, -OCO-CH=CH- and -C≡C-, m is 0, 1, or 2, A⁴, A⁵, and A⁶ are each independently selected from one of 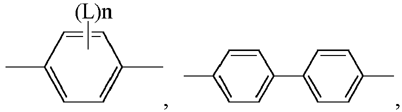 and 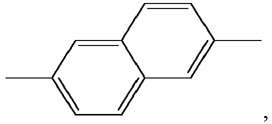 L is arbitrarily selected from one of H, F, Cl, CN, OH, NO₂, CH₃, C₂H₅, OCH₃, OC₂H₅, COCH₃, COOCH₃, COOC₂H₅, CF₃, OCF₂, and OC₂F₅, and n is 0, 1, or 2.

5. The use of the liquid crystal composition as an ink or as a colorant of claim 2, wherein the structure formula of the chiral reagent is P³-Sp³-X³-G-X⁴-Sp⁴-P⁴ or P⁵-Sp⁵-X⁵-F, wherein P³ and P⁴ are each independently selected from one of CH₂=CW-COO-, WCH=CH-O- and 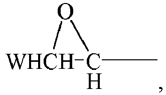 W is arbitrarily selected from one of H, -CH₃ and Cl, Sp³ and Sp⁴ are each arbitrarily selected from one of spacer groups with a chain length of 3-30 carbon atoms, X³ and X⁴ are each independently selected from one of -O-, -S-, -CO-, -COO-, -OCO-, -CO-NH-, -NH-CO-, -CH₂CH₂-, -OCH₂-, -CH₂O-, -SCH₂-, -CH₂S-, -CH=CH-, and -CH=CH-COO-, G is arbitrarily selected from one of 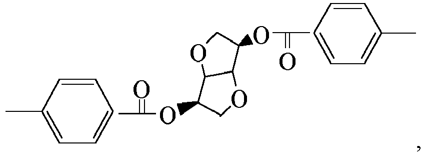 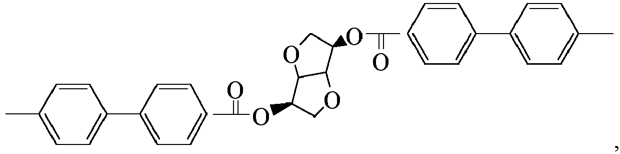 and 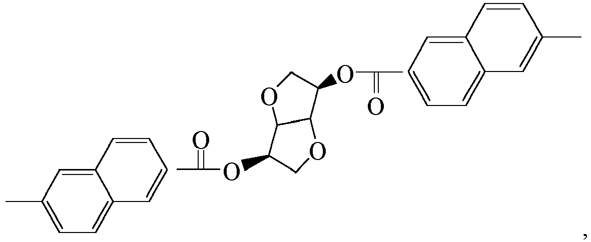 P⁵ is arbitrarily selected from one of CH₂=CW-COO-, WCH=CH-O- and 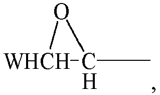 W is arbitrarily selected from one of H, -CH₃ and Cl, Sp⁵ is arbitrarily selected from one of spacer groups with a chain length of 3-30 carbon atoms, X⁵ is arbitrarily selected from one of -COO- and -CH=CH-COO-, and F is arbitrarily selected from one of 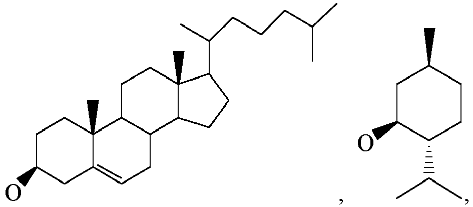 and

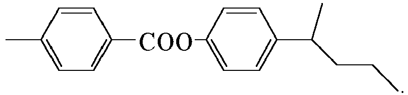

6. The use of the liquid crystal composition as an ink or as a colorant of claim 3, wherein the mono-functional liquid crystal monomer is at least one of 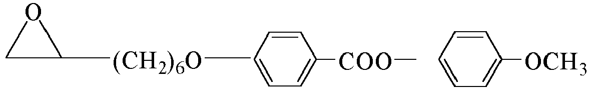 and

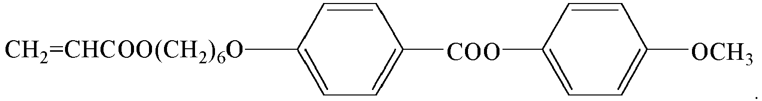

7. The use of the liquid crystal composition as an ink or as a colorant of claim 4, wherein the bi-functional liquid crystal monomer is at least one of 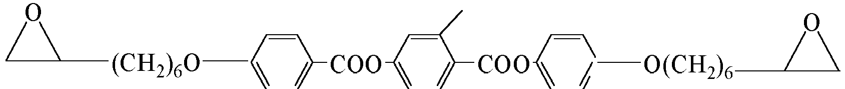 and

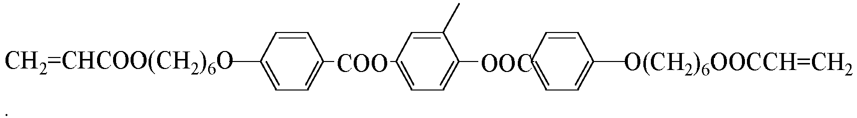

8. The use of the liquid crystal composition as an ink or as a colorant of claim 5, wherein the chiral reagent is at least one of

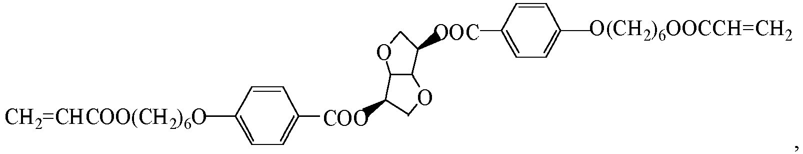

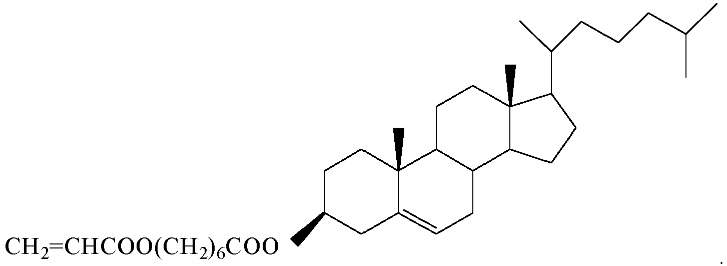

9. The use of the liquid crystal composition as an ink or as a colorant of claim 1, wherein the liquid crystal composition further comprises 0.1%-1% of an antioxidant and 0.01%-0.1% of an assistant, wherein the antioxidant is any one of hydroquinone, methoxyhydroquinone, p-benzoquinone, mono-tert-butylhydroquinone, pyrocatechol, p-tert-butylpyrocatechol, benzoquinone, 2,5-di-tert-butylhydroquinone, 2,5 -dimethyl-p-benzoquinone, anthraquinone, and 2,6-di-tert-butyl-p-cresol; and the assistant is at least one of a fluorocarbon surfactant or an organosilicon surfactant.

10. The use of the liquid crystal composition as an ink or as a colorant of claim 9, wherein the liquid crystal composition further comprises 0.1%-1% of a tackifier which is at least one of the monomers, oligomers and prepolymers of acrylates, methacrylates, and epoxy acrylates having polymerizable groups.

11. The use of the liquid crystal composition as an ink or as a colorant of any one of claims 1 to 10, wherein the photoinitiator is at least one of dimethoxybenzoin, 1-hydroxyketone, BDMB, phenyl bis(2,4,6-trimethylbenzoyl)-phosphine oxide, diazonium salt, diaryliodonium salt, triarylsulfonium salt, alkylsulfonium salt, iron arene salt, sulfonyloxyketone, and triarylsiloxane.

12. The use of the liquid crystal composition as an ink or as a colorant of any one of claims 1 to 10, wherein the organic solvent is at least one of toluene, xylene, ethylene glycol monomethyl ether, propylene glycol monomethyl ether, ethyl acetate, n-butyl acetate, n-propyl acetate, iso-butyl acetate, amyl acetate , butanone, methyl isobutyl ketone, and isophorone.

## Patentansprüche

1. Der Gebrauch einer flüsigen Kristallzusammensetzung als Tinte oder Farbstoff, wobei besagte flüssige Kristallzusammensetzung folgende Komponenten in ihren entsprechenden Massenanteilen enthält:
8%-50% eines polymerisibares flüssiges Kristallmonomers;
1%-30% eines chirales Reagenz;
0,1%-5% eines Photoinitiators, und
30%-70% eines organischen Lösemittels,
bei der nach Aushärten die flüssige Kristallzusammensetzung optische Wirkungen aufweist abhängig vom Sichtwinkel;:
**dadurch gekennzeichnet, dass** die flüssige Kristallzusammensetzung nicht flüssige Kristallmikrokapseln enthält.

2. Der Gebrauch der flüssigen Kristallzusammensetzung als Tinte oder Farbstoff gemäss Anspruch 1, bei dem
das chirale Reagenz mindestens ein Akrylat, Methakrylat, Epoxiharz, Methylepoxiharz oder ein cholesterinhaltiges Alken, eine chirale Gruppe oder chirales Zentrum von Menthol oder Isosorbitol ist; und
der Photoinitiator mindestens ein radikalfreier Initiator oder ein kationischer Initiator ist.

3. Der Gebrauch der flüssigen Kristallzusammensetzung als Tinte oder Farbstoff gemäss Anspruch 2, bei dem das polymerisierbare, flüssige Kristallmonomer mindestens ein monofunktionelles, flüssiges Kristallmonomer oder ein bifunktionelles, flüssiges Kristallmonomer enthält; die Strukturformel des monofuntionellen, flüssigen Kristallmonomers P-Sp-X-M-R ist, wobei P willkürlich gewählt wird aus CH₂=CW-COO-, WCH=CH-O-, und 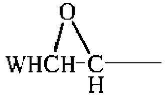 wird willkürlich gewählt aus H, -CH₃, und Cl, und Sp wird willkürlich gewählt aus einer Raumgruppe mit einer Kettenlänge von 3-30 Kohlenstoffatomen, X wird willkürlich gewählt aus -0-, -S-, -CO-, -COO-, -OCO-, -CO-NH-, -NH -CO-,-CH₂CH₂-, -OCH₂-, -CH₂O-, -SCH₂-, -CH₂S-, -CH=CH- und -CH=CH-COO- , M ist eine Mesonengruppe und R wird willkürlich gewählt aus H, CN, Cl, Alkoxyl, geradkettigen Alkanen, verzweigten Alkanen und Zykloalkanen, wobei die Strukturformel der Mesonengruppe M -A¹-Z¹-(A²-Z²-)ₘ-A³- ist, Z¹ und Z² werden unbhängig voneinander gewählt aus -COO-,-OCO-,-CH₂CH₂-,-OCH₂-,-CH₂O-,-CH=CH-,-CH=CH-COO-,---OCO-CH=CH- und -C≡C-, m ist 0, 1 oder 2, A¹, A² und A³ werden unabhängig voneinander gewählt aus 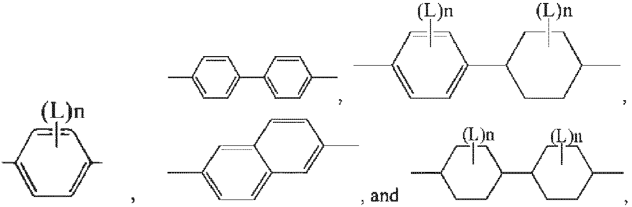 L wird willkürlich gewählt aus H, F, Cl, CN, OH, NO₂, CH₃, C₂H₅, OCH₃, OC₂H₅, COCH₃, COOCH₃, COOC₂H₅, CF₃, OCF₂ und OC₂F₅, und n ist 0, 1 oder 2.

4. Der Gebrauch der flüssigen Kristallzusammensetzung als Tinto oder Farbstoff gemäss Anspruch 2, und bei dem die Strukturformel des bifunktionellen, flüssigen Kristallmonomers P¹-Sp¹-X¹-Y-X²-Sp²-P² ist, wobei P¹ und P² willkürlich gewählt werden aus CH₂=CW-COO-, WCH=CH-O- and 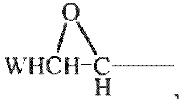 W wird willkürlich gewählt aus H, -CH₃ und Cl, Sp¹ und Sp² werden willkürlich gewählt aus einer Raumgruppe mit einer Kettenlänge von 3-30 Kohlenstoffatomen, X¹ und X² werden jeweils willkürlich gewählt aus -O-, -S-, -CO-, -COO-, -OCO-, -CO-NH-, -NH-CO-, -CH₂CH₂-, -OCH₂-, -CH₂O-, -SCH₂-, -CH₂S-, -CH=CH- und -CH=CH-COO-, Y ist eine Mesonengruppe, die Strukturformel der Mesonengruppe Y ist -A⁴-Z¹--A⁵-Z⁴⁾ₘ-A⁶-, Z³ und Z⁴ sind jeweils unabhängig voneinander -COO-, -OCO-, -CH₂CH₂-, OCH₂-, -CH₂O-, -CH=CH-, -CH=CH-COO-, -OCO-CH=CH- und -C≡C-, m ist 0, 1 oder 2, A⁴, A⁵ und A⁶ werden jeweils unabhängig voneinander gewählt aus: 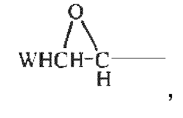 L wird willkürlich gewählt aus H, F, Cl, CN, OH, NO₂, CH₃, C₂H₅, OCH₃, OC₂H₅, COCH₃, COOCH₃, COOC₂H₅, CF₃, OCF₂ und OC₂F₅, und n ist 0, 1 oder 2.

5. Der Gebrauch der flüssigen Kristallzusammensetzung als Tinto oder als Farbstoff gemäss Anspruch 2, bei dem die Strukturformel des chiral Reagenz wie folgt ist:
P³-Sp³-X³-G-X⁴-Sp⁴-P⁴ oder P⁵ oder Sp⁵-X⁵-F, wobei P³ und P⁴ jeweils unabhängig voneinander gewählt werden aus CH₂= CW-COO-, WCH=CH-O- und 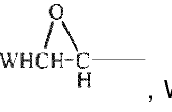 W wird willkürlich gewählt aus H, -CH₃ und Cl, Sp³ und Sp⁴ werden jeweils willkürlich gewählt aus Raumgruppen mit einer Kettenlänge von 3-30 Kohlenstoffatomen, X³ und X⁴ werden jeweils unabhängig voneinander gewählt aus -O-, -S-, -CO-, -COO-, -OCO-, -CO-NH-, -NH-CO-, -CH₂CH₂-, - OCH₂-, -CH₂O-, -SCH₂-, -CH₂S-, -CH=CH- und -CH=CH-COO-, G wird willkürlich gewählt 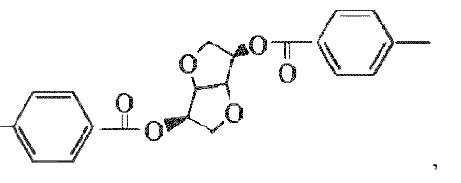 aus 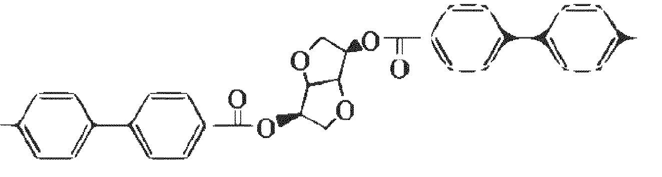 und 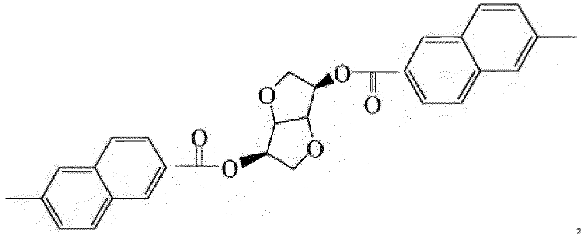 P⁵ wird willkürlich gewählt aus CH₂=CW-COO-, WCH=CH-O- und 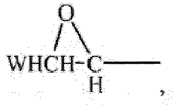 W wird willkürlich gewählt aus H, -CH₃ und Cl, Sp⁵ wird willkürlich gewählt aus Raumgruppen mit einer Kettenlänge von 3-30 Kohlenstoffatomen, X⁵ wird willkürlich gewählt aus -COO- und -CH=CH-COO-, und F wird willkürhlich gewählt aus 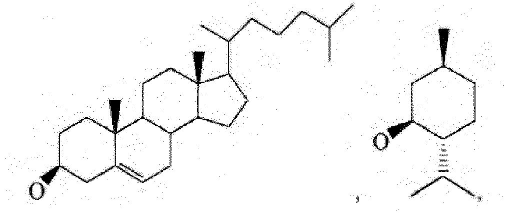 und

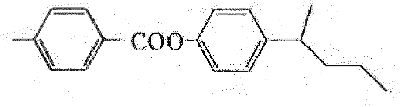

6. Der Gebrauch der flüssigen Kristallzusammensetzung als Tinte oder Farbstoff gemäss Anspruch 3, bei dem das monofunktionelle flüssige Kristallmonomer mindestens eins von folgenden ist: 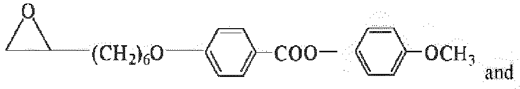 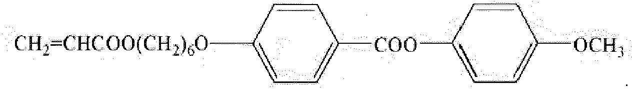 und

7. Der Gebrauch der flüssigen Kristallzusammensetzung als Tinte oder Farbstoff gemäss Anspruch 4, bei dem das bifunktionelle flüssige Kristallmonomer mindestens ein von folgenden ist: 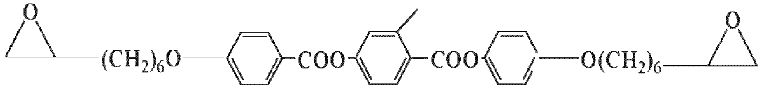 und

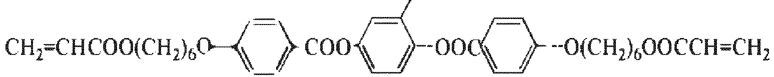

8. Der Gebrauch der flüssigen Kristallzusammensetzung als Tinte oder Fabbstoff gemäss Anspruch 5, bei dem das chirale Reagenz mindestens eins von folgenden ist:

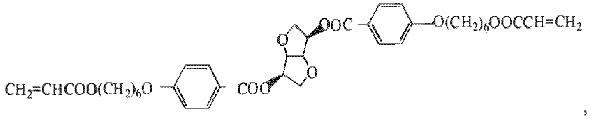

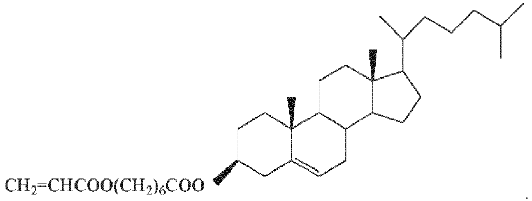

9. Der Gebrauch der flüssigen Kristallzusammensetzung als Tinte oder Farbstoff gemäss Anspruch 1, bei dem die flüssige Kristallzusammensetzung weiter 0,1%-1% eines Antioxidanses und 0,01%-0,1% eines Hilfsmittels enthält, wobei das Antioxidans eins folgender ist: Hydrochinon, Methoxyhydrochinon, p-Benzochinon, mono-tert-Butylhydrochinon, Pyrocatechin, p-tert.Butylpyrocatechin, Benzochinon, 2,5-di-tert-Butylhydrochinon, 2,5-Dimethyl-p-benznochinon, Anthrachinon und 2,6-di-tert-Butyl-p-Kresol und das Hilfsmittel mindestens entweder ein Fluorkohlenstofftensid oder ein Organosilikontensid.

10. Der Gebrauch der flüssigen Kristallzusammensetzung als Tinte oder Farbstoff gemäss Anspruch 9, bei dem die flüssige Kristallzusammensetzung weiter 0,1%-1% eines Tackifiers enthält, der mindestens Monomeracrylat, Oligomeracrylat oder Prepolymeracrylat, -methacrylat oder Epoxiacrylate mit polymerisierbarenGruppen ist.

11. Der Gebrauch der flüssigen Kristallzusammensetzung als Tinte oder Farbstoff gemäss irgendeinem der Ansprüche 1 bis 10, bei dem der Photoinitiator mindestens Dimethoxybenzoin, 1-Hydroxyketon, BDMB, Phenyl bis(2,4,6-trimethylbenzoyl)-phosphin-oxid, Diazoniumsalz, Diaryliodoniumsalz, Triarylsulfoniummsalz, Alkylsulfoniumsalz, Eisen-Arensalz, Sulfonyloxyketon und Trialylsiloxan ist.

12. Der Gebrauch der flüssigen Kristallzusammensetzung als Tinte oder Farbstoff gemäss irgendeinem der Ansprüche 1 bis 10, bei dem das organische Lösemittel mindestens Toluen, Xylol, Ethylenglykol-Monomethyl-Ether, Propylen-Glykol-Monomethyl-Ether, Ethyl-Azetat, n-Butyl-Azetat, n-Propyl-Azetat, iso-Butyl-Azetat, Amylazetat, Butanon, Methyl-Isobutyl-Keton oder Isophoron ist.

## Revendications

1. L'utilisation d'une composition à cristaux liquides comme encre ou colorant, ladite composition à cristaux liquides comprenant les éléments suivants avec le pourcentage de masse respectif:
8%-50% d'un monomère à cristaux liquides polymérisable;
1%-30% d'un réactif chiral;
0,1%-5% d'un photo-initiateur; et
30%-70% d'un solvant organique,
où après le durcissement, la composition à cristaux liquides présente un effet d'optique dépendant de l'angle de visibilité;
elle est **caractérisée en ce que** la composition à cristaux liquides ne contient pas de microcapsules de cristaux liquides.

2. L'utilisation de la composition à cristaux liquides comme encre ou colorant de la revendication 1, où le réactif chiral est au moins l'un des suivants: acrylates, méthacrylates, résines époxy, résines époxy de méthyle et des alcènes contenant du cholestérol, du menthol et des groupes chiraux d'isosorbide ou centres chiraux ; et
le photo-initiateur est au moins un initiateur de radicaux libres ou un initiateur cationique.

3. L'utilisation de la composition à cristaux liquides comme encre ou colorant de la revendication 2, où le monomère à cristaux liquides polymérisable comprend au moins un monomère à cristaux liquides monofonctionnel et un monomère à cristaux liquides bi-fonctionnel; la formule structurelle du monomère à cristaux liquides monofonctionnel est P-Sp-X-M-R, où P est sélectionné de manière arbitraire de l'un des CH2=CW-COO-, WCH=CH-O-, et 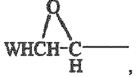 W est sélectionné de manière arbitraire de l'un des H, -CH₃ et Cl, Sp est sélectionné de manière arbitraire de l'un des groupes d'espacement ayant une longueur de chaîne de 3-30 atomes de carbone; X est sélectionné de manière arbitraire de l'un des -O-, -S-, CO-, -COO-, -OCO-, -CO-NH-, NH-CO-, -CH₂CH₂-, -OCH₂-, -CH₂O-, -SCH₂-, - CH₂S-, -CH=CH- et -CH=CH-COO-; M est un groupe mésogène, et R est sélectionné de manière arbitraire de H, CN, Cl, alcoxyle, alcanes à chaînes droites, alcanes ramifiés et cycloalcanes; où la formule structurelle du groupe mésogène M est -A¹-Z¹-(A²-Z²-)ₘ-A³-, Z¹ et Z² sont sélectionnés de manière indépendante de l'un des -COO-, -OCO-, -CH₂CH₂-, -OCH₂-, -CH₂O-, -CH=CH-, -CH=CH-COO-, -OCO-CH=CH-, et -C≡C-; m est 0, 1 ou 2, A¹, A² et A³ sont sélectionnés de manière indépendante de l'un de 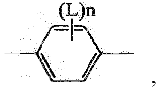 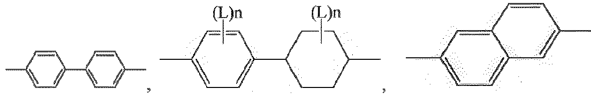 et 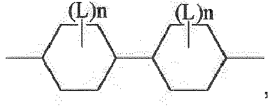 L est sélectionné de manière arbitraire de l'un de H, F, Cl, CN, OH, NO₂, CH₃, C₂H₅, OCH₃, OC₂H₅, COCH₃, COOCH₃, COOC₂H₅, CF₃, OCF₂ et OC₂F₅ ; et n est 0, 1 ou 2.

4. L'utilisation de la composition à cristaux liquides comme encre ou colorant de la revendication 2, où la formule structurelle du monomère à cristaux liquides bi-fonctionnel est P¹-Sp¹-X¹-Y-X²-Sp²-P², où P1 et P2 sont sélectionnés de manière arbitraire de l'un des CH₂=CW-COO-, WCH=CH-O- et 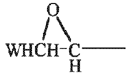 W est sélectionné de manière arbitraire de l'un des H, -CH₃ et Cl, Sp¹ et Sp² sont sélectionnés de manière arbitraire de l'un des groupes d'espacement ayant une longueur de chaîne de 3-30 atomes de carbone ; X¹ et X² sont sélectionnés de manière arbitraire chacun d'eux de l'un des -O-, -S-, -CO-, -COO-, -OCO-, -CO-NH-, -NH- CO-, -CH₂CH₂-, -OCH₂-, -CH₂O-, -SCH₂-, -CH₂S-, -CH=CH- et -CH=CH COO-; Y est un groupe mésogène; la formule structurelle du groupe mésogène Y est -A⁴-Z3-(A5-Z4)ₘ-A⁶- ; Z³ et Z⁴ sont sélectionnés chacun d'eux de manière indépendante de l'un des -COO-, -OCO-, -CH₂CH₂-, -OCH₂-, -CH₂O-, -CH=CH-, -CH=CH-COO-, -OCO-CH=CH-, et -C≡C- ; m est 0, 1 ou 2 ; A₄, A₅ et A₆ sont sélectionnés chacun d'eux de manière indépendante de l'un des 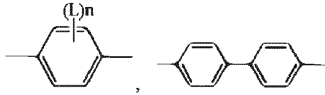 et 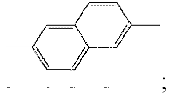 L est sélectionné de manière arbitraire de l'un des H, F, Cl, CN, OH, NO₂, CH₃, C₂H₅, OCH₃, OC₂H₅, COCH₃, COOCH₃, COOC₂H₅, CF₃, OCF₂, et OC₂F5 ; et n est 0, 1 ou 2.

5. L'utilisation de la composition à cristaux liquides comme encre ou colorant de la revendication 2, où la formule structurelle du réactif chiral est P³-Sp³-X³-G-X⁴-Sp⁴-P⁴ ou P⁵-Sp5 X⁵-F, où P³ et P⁴ sont sélectionnés chacun d'eux de manière indépendante de l'un des CH₂=CW-COO-, WCH=CH-O- et 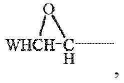 W est sélectionné de manière arbitraire de l'un des H, -CH₃ et Cl ; Sp³ et Sp⁴ sont sélectionnés chacun d'eux de manière arbitraire de l'un des groupes d'espacement ayant une longueur de chaîne de 3-30 atomes de carbone; X³ et X⁴ sont chacun d'eux sélectionnés de manière indépendante de l'un des -O-, -S-, -CO-, -COO-, -OCO-, -CO- NH-, -NH- CO-, -CH₂CH₂-, -OCH₂-, -CH₂O-, -SCH₂-, -CH₂S-, -CH=CH- et -CH=CH-COO- ; G est sélectionné de manière arbitraire de l'un des 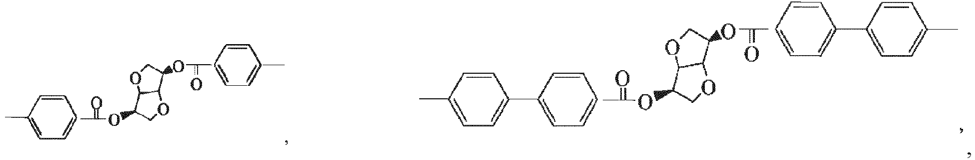 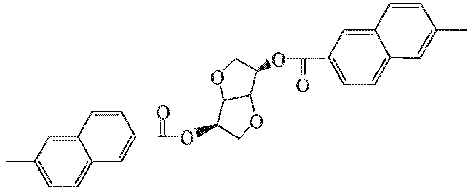 et P⁵ est sélectionné de manière arbitraire de l'un des CH₂=CW-COO- WCH=CH-O- et 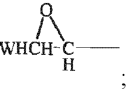 W est sélectionnée de manière arbitraire de H, -CH₃ et Cl; Sp⁵ est sélectionné de manière arbitraire de l'un des groupes d'espacement ayant une longueur de chaîne de 3-30 atomes de carbone ; X5 est sélectionné de manière arbitraire de l'un des -COO- et -CH=CH-COO-; et F est sélectionné de manière arbitraire de l'un des 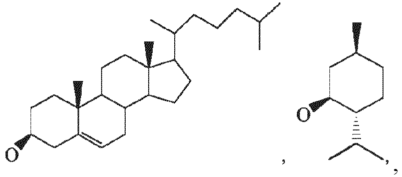 et

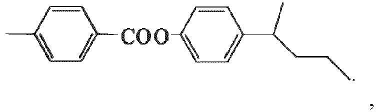

6. L'utilisation de la composition à cristaux liquides comme encre ou colorant de la revendication 3, où le monomère à cristaux liquides monofonctionnel est au moins l'un des 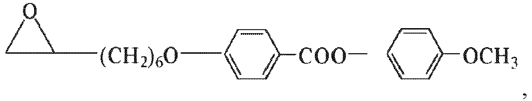 et

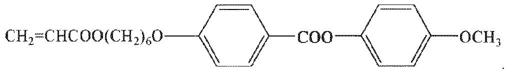

7. L'utilisation de la composition à cristaux liquides comme encre ou colorant de la revendication 4, où le monomère à cristaux liquides bi-fonctionnel est au moins l'un des 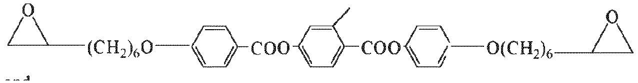 et

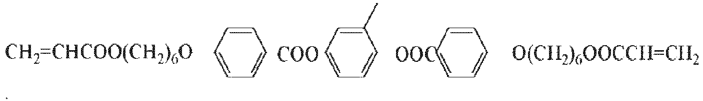

8. L'utilisation de la composition à cristaux liquides comme encre ou colorant de la revendication 5, où le réactif chiral est au moins l'un des

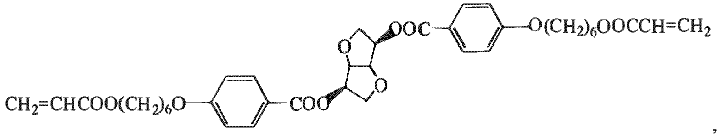

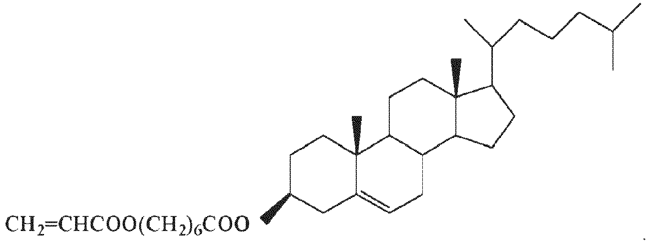

9. L'utilisation de la composition à cristaux liquides comme encre ou colorant de la revendication 1, où la composition à cristaux liquides comprend en outre 0.1%-1% d'un antioxydant et 0.01%-0.1% d'un agent, où l'antioxydant est l'un quelconque de : l'hydroquinone, méthoxyhydroquinone, p-benzoquinone, mono-tert-butylhydroquinone, pyrocatéchol, p-tert-butylpyrocathécol, benzoquinone, 2,5-di-tert-butylhydroquinone, 2,5-diméthyl-p-benzoquinone, anthraquinone et 2,6-di-tert-butyl-p-crésol ; et l'agent est au moins un agent tensioactif fluorocarboné ou un agent tensioactif organosilicié.

10. L'utilisation de la composition à cristaux liquides comme encre ou colorant de la revendication 9, où la composition à cristaux liquides comprend en outre 0.1%-1% d'un adhésif qui est au moins l'un des monomères, oligomères et prépolymères des acrylates, méthacrylates et époxy acrylates comprenant des groupes polymérisables.

11. L'utilisation de la composition à cristaux liquides comme encre ou colorant de l'une quelconque des revendications 1 à 10, où le photo-initiateur est au moins l'un des diméthoxybenzoïque, 1-hydroxycétones , BDMB, phényle bis (2,4,6- triméthylbenzoyl)-oxyde de phosphine, sel de diazonium, sel de diaryliodonium, sel de triaryl-sulfonium, sel d'alkyl-sulfonium, sel de fer-arène, sulfonyloxycétone et triaryl-siloxane.

12. L'utilisation de la composition à cristaux liquides comme encre ou colorant de l'une quelconque des revendications 1 à 10, où le solvant organique est au moins l'une des substances suivantes : toluène, xylène, éther monométhylique de l'éthylène-glycol, éther monométhylique du propylèneglycol, acétate d'éthyle, acétate de n-butyle, acétate de n-propyle, acétate d'isobutyle, acétate d'amyle, butanone, méthylisobutylcétone et isophorone.
